# EUROPEAN PATENT APPLICATION

(11) **EP 3 240 040 A1**
(43) Date of publication of application: **01.11.2017**
(21) Application number: 16167002.1
(22) Date of filing: 26.04.2016
(51) Int. Cl.: H01L 29/739, H01L 29/66, H01L 29/08

(54) **INSULATED GATE BIPOLAR TRANSISTOR AND METHOD FOR MANUFACTURING SUCH AN INSULATED GATE BIPOLAR TRANSISTOR**

(71) Applicant: ABB Schweiz AG, 5400 Baden (CH)
(72) Inventor: Kopta, Arnost, 8049 Zürich (CH); Corvasce, Chiara, 8962 Bergdietikon (CH); Rahimo, Munaf, 5619 Uezwil (CH); Matthias, Sven, 5600 Lenzburg (CH); Janisch, Wolfgang, 5726 Unterkulm (CH)
(74) Representative: ABB Patent Attorneys

(57) **Abstract**

An insulated gate bipolar is produced, wherein the following steps are performed:
(a) providing a lowly n doped substrate (1) having an emitter side (20) and a collector side (27),
(b) forming n and p doped layers on the emitter side (20),
(c) thinning the substrate (1) on the collector side (27),
(d) implanting an n first dopant (82) on the collector side (27) into a depth of at most 2 µm,
(e) forming a first buffer layer (8) by annealing the first dopant (82),
(f) applying a surface layer comprising an n second dopant on top of the collector side (27),
(g) forming a second buffer layer (9) by annealing the second dopant, wherein the second buffer layer (9) having a lower maximum doping concentration than the first buffer layer (8),
(h) applying a p third dopant at the collector side (27),
(i) forming a collector layer (6) by annealing the third dopant.

## Description

### Technical Field

The invention relates to the field of power electronics and more particularly to a method for manufacturing an insulated gate bipolar transistor according to the claim 1 and to an insulated gate bipolar transistor according to the claim 12.

### Background Art

From WO 2009/043870 A1 a prior art controlled-punch-through insulated gate bipolar transistor (IGBT) is known, which has between an (n-) lowly doped drift layer 5 and a p doped collector layer 6 a buffer layer structure with a deep and shallow buffer layer 88, 98 and a low doped buffer layer in between. Fig 12 shows a doping profile for an IGBT as known from WO 2009/043870 A1 in depth direction. The p doped layers such as a p base layer 4 on an emitter side 20 and the p collector layer 6 on the collector side 27 are shown as dotted lines, whereas the n doped layers (i.e. drift layer 5, deep buffer layer 88 and shallow buffer layer 98) are shown by continuous lines. The electric field (dashed line) is stopped within the deep buffer layer 88.

The deep buffer layer 88 contacts the drift layer 5. It has a higher doping concentration than the drift layer 5. Towards the collector side 27 of the device, a higher doped, shallower buffer layer is arranged. The maximum doping concentration and thickness of the deep buffer layer is chosen such that an electric field is stopped within the deep buffer layer 88. Between the deep and shallow buffer layers 88, 98, an area of low doping concentration is allocated. In this region, the bipolar transistor current gain of the device, being defined as the ratio of the collector and base current, is reduced. The shallow buffer layer 98 further reduces the bipolar current gain and makes the device insensitive to variations of the depth of the deep buffer layer 88. Such a device is less sensitive to the position of such buffer layer than in prior art devices not having such a multilayer buffer structure, thereby simplifying the manufacturing improving the switching properties and electrical properties of the device. Furthermore, by having such a multilayer buffer layer structure, the buffer layers can be made thinner, resulting in much lower losses than in other prior art devices. However, as the doping concentration of the shallow buffer layer 98 is high, the collector layer 6 needs a higher p doping concentration than the n doping concentration of the shallow buffer layer 98, i.e. it is an overcompensated layer.

Furthermore, high energies are needed for the implant of the dopant for the deep buffer layer 88. If protons are used as dopant, they create many undesired defects, which degrade the electric properties. Thus, the n doping concentration is a result of vacancies generated due to the proton implantation and not as in the electrical activation of the implanted species. If other dopants are used, the energies have to be higher than 1 MeV to implant the dopant in the desired high depth.

### Disclosure of Invention

It is an object of the invention to provide a method for producing a punch-through semiconductor device with improved electrical properties, which device is as thin as possible and easy to produce.

This object is achieved by the method for producing a semiconductor module according to claim 1 and the device according to claim 12.

In the inventive semiconductor device, the electric field is stopped in the first buffer layer. The bipolar gain of the device, being defined as the ratio of the collector and base current, is further reduced compared to the prior art devices, because doping concentrations and thicknesses of the buffer and collector layer can be optimized. The distance from the pn-junction at the interface between the second buffer layer and the collector layer can be kept small due to the low doping concentration of the second buffer layer, so that the bipolar gain is reduced. The doping concentration of the collector layer is not much influenced by the doping concentration of the second buffer layer, because the buffer layer has low doping concentration, so that undesired high overcompensation can be avoided. Furthermore, the doping concentration in the inventive device can be kept much lower, so that overall losses of the device are lowered.

The second buffer layer further reduces the bipolar current gain and makes the device insensitive to variations of the depth of the first buffer layer. By having a device, which is less sensitive to the position of the first buffer layer, manufacturing of such a device is simplified and the switching properties and electrical properties of the device are improved. Furthermore, by having the inventive buffer layer structure, the buffer layers can even be made thinner, resulting in even lower losses than in the prior art devices. The inventive buffer layer combination differs from the prior art in that it provides a low energy and controlled dose first buffer layer with an n-type concentration achieved via the electrical activation of the n-type dopants followed by a second buffer layer deposited on the surface with a well-controlled n-type doping and thickness for lowering the bipolar gain. A collector layer is subsequently added by p-type deposition or implantation which does not overcompensate the first buffer layer.

Further preferred embodiments of the inventive subject matter are disclosed in the dependent claims.

### Brief Description of Drawings

The subject matter of the invention will be explained in more detail in the following text with reference to the attached drawings, in which:
- FIG 1: shows a doping profile of an IGBT according to the invention in depth direction;
- FIG 2: shows a cross sectional view on an IGBT according to the invention;
- FIG 3: shows a cross sectional view on another IGBT according to the invention;
- FIGs 4 to 10: show manufacturing step for manufacturing an IGBT according to the invention;
- FIG 11: shows a doping profile of an IGBT according to the invention in depth direction having a third buffer layer;
- FIG 12: shows a doping profile of a prior art IGBT.

The reference symbols used in the figures and their meaning are summarized in the list of reference symbols. Generally, alike or alike-functioning parts are given the same reference symbols. The described embodiments are meant as examples and shall not confine the invention.

### Modes for Carrying out the Invention

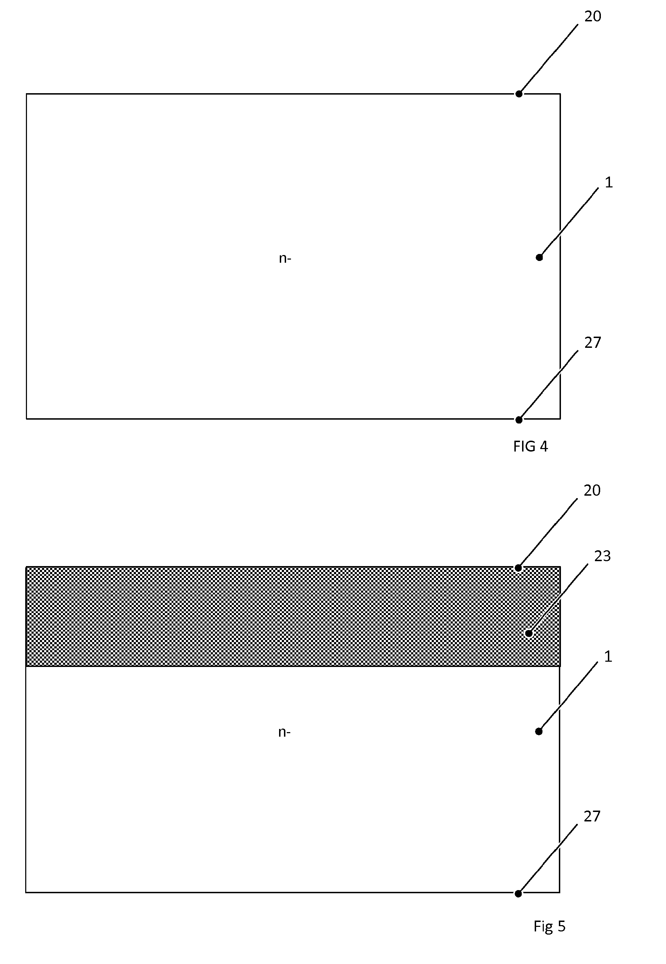

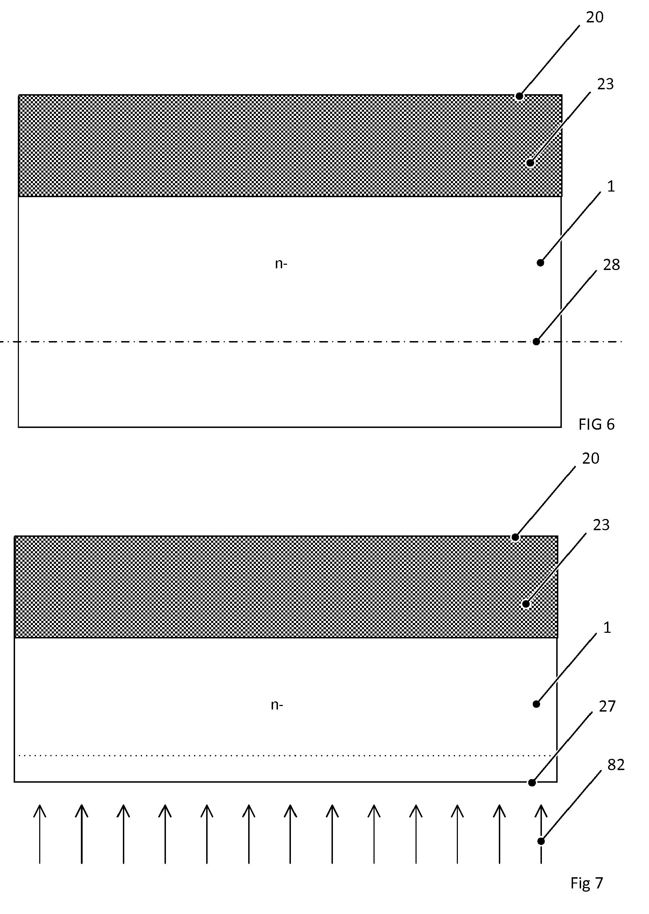

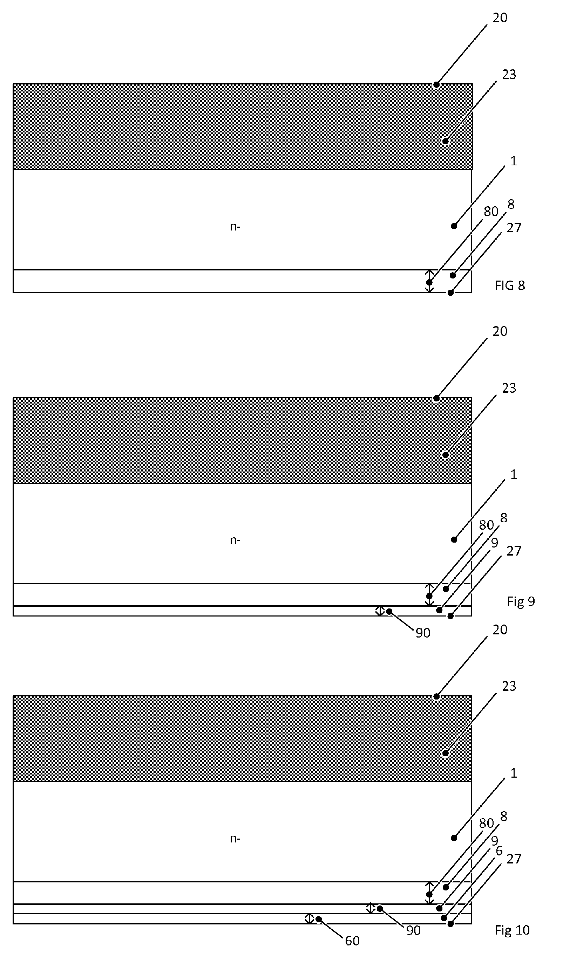

For manufacturing an inventive control insulated gate bipolar transistor steps for producing the semiconductor device being performed in the following order:
(a) providing a lowly (n-) doped substrate 1, which is of a first conductivity type, wherein the substrate 1 has an emitter side 20 and a collector side 27 opposite to the emitter side 20 (FIG 4),
(b) forming n and p doped layers, which are layers of the first and second conductivity type, wherein the second conductivity type is different from the first conductivity type, on the emitter side 20 (FIG 5),
(c) thinning the substrate 1 on the collector side 27 (FIG 6),
(d) implanting a first n dopant 82 into the substrate 1 from the collector side 27 into a depth of at most 2 µm (FIG 7),
(e) forming a first buffer layer 8 by annealing the first dopant 82 (FIG 8),
(f) applying a surface layer comprising a second dopant on top of the substrate on the second main side,
(g) forming a second buffer layer 9 by annealing the second dopant (FIG 9), wherein the second buffer layer 9 having a lower maximum doping concentration than the first buffer layer 8,
(h) applying a p third dopant at the collector side 27,
(i) forming a collector layer 6 by annealing the third dopant (FIG 10).

The substrate 1 provided in step (a) (FIG 4) is made of silicon. Exemplarily, the substrate 1 has a constantly low doping concentration. Such part of the substrate 1 having this low doping concentration will be the drift layer 5 in the finalized IGBT. Therein, the substantially constant doping concentration of the substrate 1 / drift layer 5 means that the doping concentration is substantially homogeneous throughout the substrate 1 / drift layer 5, however without excluding that fluctuations in the doping concentration within the drift layer being in the order of a factor of one to five may be possibly present due to e.g. a fluctuations in the epitaxial growth process. The drift layer thickness and doping concentration is chosen due to the application needs. An exemplary doping concentration of the drift layer 5 is between 5 *10¹² cm⁻³ and 5 * 10¹⁴ cm⁻³.
In step (b) layers 23 on the emitter side 20 such as a p doped base layer 4 and an n doped source layer 3 (i.e. layers 23 of the first and second conductivity type) are formed (FIG 5). The layers 23 are shown in the figures as a checkered area to indicate that different layers may be formed on the emitter side 20 and also different types of gate electrodes (having a gate layer and insulating layer surrounding the gate layer) may be formed. By forming source and base layers 3, 4 as well as gate electrodes 7, active cells are formed, which may be surrounded by edge termination structures. Exemplarily, all layers on the emitter side 20 are formed in step (b), exemplarily also the gate electrode 7. An emitter electrode 2 may also be formed in this step or later, after having formed the layers on the collector side 27. The emitter electrode 2 thus may be formed together with a collector electrode 25 or one after each other.

The manufacturing processes for forming the layers 3, 4 (or other further layers like n doped enhancement layers and edge terminations) and gate electrode 2 on the emitter side 20 are well known to the persons skilled in the art and are therefore, here not described in more detail. Any of the well-known methods may be used to form any of the well-known designs.

The p doped base layer 4 surrounds the n doped source layer 3 such that the source layer 3 is separated from the drift layer 5 by the base layer 4. Base and source layer 4, 3 are in electrical contact with an emitter electrode 2. A gate electrode 7 is manufactured on the emitter side 20. The gate electrode 7 may either be a trench gate electrode or a planar gate electrode.

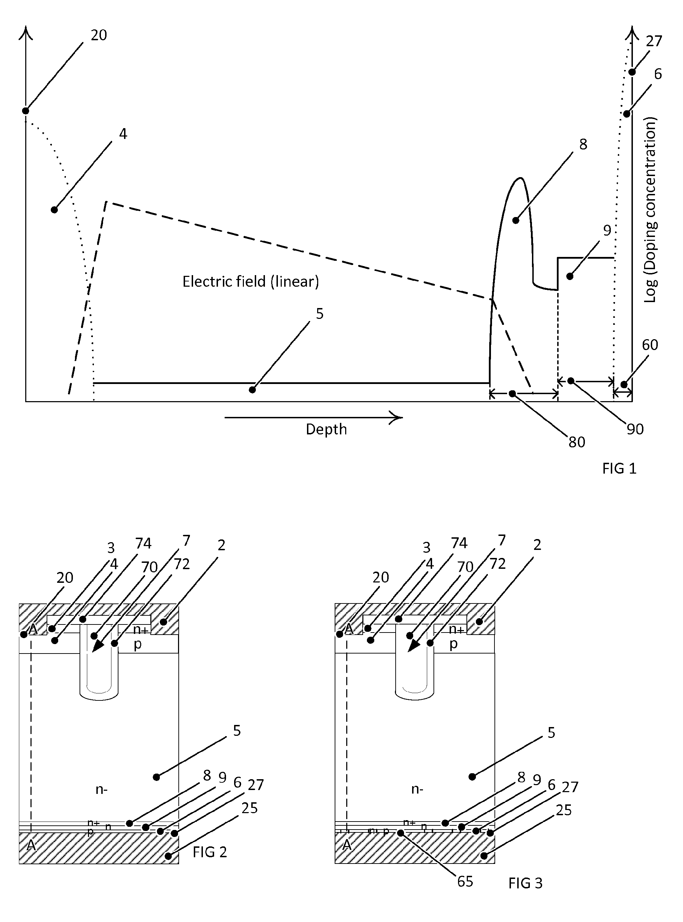

The gate electrode 7 (as shown in FIG 2 and 3) comprises an electrically conductive gate layer 70 and an insulating layer, which electrically insulates the gate layer 70 from the at least one base layer 4, the source layer 3 and the drift layer 5. Exemplarily, the gate layer 70 is embedded and completely covered by the insulating layer.

Exemplarily, the insulating layer comprises a first electrically insulating layer 72, and a second electrically insulating layer 74. The second electrically insulating layer 74 covers the first electrically insulating layer 72. The first and second insulating layers 72, 74 may be made of an insulating material, wherein also a dielectric like a metal oxide, exemplarily Silicon dioxide, which shall be considered as an insulating layer. The covering second insulating layer 74 can also be made as a stack of different insulating layers, but the second insulating layer 74 can also be made of the same material as the first insulating layer, exemplarily both layers 72, 74 .are made of a silicon dioxide.

For an IGBT with a gate layer 70 formed as a planar gate electrode the first electrically insulating layer 72 is arranged on top of the emitter side 20. In between the first and second electrically insulating layers 72, 74, the gate layer 70 is embedded, exemplarily it is completely embedded in the insulating layers. Thus, the gate layer 70 is separated from the drift layer 5, the source layer 3 and the base layer 4 by the first electrically insulated layer 72. The gate layer 70 is exemplarily made of a heavily doped poly-silicon or a metal like aluminum.

The gate electrode 7 may also be designed as a trench gate electrode (FIG 2 and 3). Again, the trench gate electrode comprises an electrically conductive layer 70 and a first electrically insulating layer 72, which surrounds and thus separates the electrically conductive layer 70 from the drift layer 5, the base layer 4 and the source layer 3. Exemplarily, a second insulating layer 74 is arranged between the electrically conductive layer 70 and the first main electrode 2. The trench gate electrode is arranged lateral to the base layer 4 in a plane parallel to the first main side 20. The trench gate electrode extends from the emitter side 20 up to a trench gate electrode depth.

In step (c), i.e. after having formed all layers on the emitter side 20, the substrate 1 is thinned on the collector side 27 to its final thickness (indicated by the dashed/dotted line in FIG 6). The substrate is thinned to a minimum wafer thickness during manufacturing. After the thinning, layers are formed in and on top of the substrate 1 on the collector side 27.

In step (d) and (e) the first buffer layer 8 is formed. First, a first dopant 82 is implanted into the substrate 1 on the collector side 27 (FIG 7). The first dopant 82 may be Phosphorous, but other dopants such as Arsenic and Antimony may also be implanted, wherein a lighter dopant has the advantage of needing lower energy to get implanted into the desired depth. Exemplarily, an energy of 100 to 600 keV is applied for the implantation. The first dopant 82 may also be implanted by implantation at different energies, i.e. thereby creating a wider doping profile.

The first dopant 82 is implanted into a depth of at most 2 µm or of at most 1 µm (dotted line in FIG 7). The fist dopant is implanted with a dose of 1 * 10¹² cm⁻² up to 1 * 10¹⁴ cm⁻² in order to achieve a maximum doping concentration for the first buffer layer of 1 * 10¹⁶ cm⁻² up to 5 * 10¹⁷ cm⁻³, exemplarily 5 * 10¹⁶ cm⁻² up to 5 * 10¹⁷ cm⁻³ in the finalized device.

Then in step (e) the first buffer layer 8 is formed by annealing the first dopant 82 (FIG 8). This step is exemplarily performed at a temperature of ≤ 500 °C or by laser anneal. By both methods, the first dopant does not diffuse far into the substrate 1, so that a first buffer layer thickness 80 is at most 2 µm or at most 1 µm. The low temperature process or laser anneal ensures that the layers on the emitter side formed before are not destroyed by the annealing.

The maximum doping concentration of the first buffer layer 8 and the first buffer layer thickness 80 is chosen such that the electric field is stopped within the first buffer layer 8 during operation of the finalized IGBT.

The first buffer layer 8 may be distinguished from the drift layer 5 may the n doping concentration, which decreases from the maximum doping concentration of the first buffer layer 8 till it reaches the constant doping concentration of the drift layer 5. Thus, the first buffer layer 8 is an n doped region towards the collector side 27 having higher doping concentration than the drift layer 5.

After having formed the first buffer layer 8, a surface layer is applied on the first buffer layer 8 (i.e. on the collector side 27). Exemplarily, the surface layer is deposited as an amorphous silicon layer or a polycrystalline silicon layer. In an exemplary embodiment, the surface layer is pre-doped with an n second dopant. The surface layer is formed on top of the first buffer layer 8, i.e. it is a layer that is not infiltrating into the substrate 1, but is created on the surface of the substrate 1. Thus, the surface layer does not overlap with the previously formed first buffer layer 8. The collector side 27 shall be in all cases the surface of the substrate/doped layers on the side, at which later the collector electrode 25 will be formed. That means that after having formed the second buffer layer 9, the side of the second buffer layer 9 facing away from the first buffer layer 8 shall be considered as the collector side 27.

In an exemplary embodiment, in step (f) the second dopant is implanted into the surface layer after having formed the surface layer. The second dopant implantation may be the sole dopant, of which the second buffer layer 9 is formed, or a pre-doped amorphous silicon layer or a polycrystalline silicon layer may be deposited. Additionally to the pre-doped layer, a second dopant may be implanted. As the second dopant for implantation, Phosphorous may be used, whereas the second dopant applied in the pre-doped surface layer any appropriate second dopant may be used. That means that different second dopants may be used as pre-doping and implanted doping. In the case of a pre-doped layer and implantation, both n dopants shall be regarded as the second dopant. The second dopant may be implanted with a dose of 1 * 10¹² cm⁻² up to 1 * 10¹³ cm⁻². With such a dose, a second buffer layer 9 having a maximum doping concentration of 1 * 10¹⁶ cm⁻³ up to 1 * 10¹⁷ cm⁻³ may be achieved. A second buffer layer 9 formed by a pure pre-doped layer may exemplarily have a maximum doping concentration of 1 * 10¹⁴ cm ² up to 1 * 10¹⁶ cm⁻³.

The surface layer may have a thickness of 0.5 to 5 µm or of 0.5 to 2 µm. As the surface layer formed as an amorphous silicon layer or a polycrystalline silicon layer does not diffuse, the thickness of the second buffer layer 9 is the same as the thickness of the surface layer.

The surface layer is then annealed, thereby forming the second buffer layer 9 (FIG 9). Exemplarily, the annealing is performed at a temperature of at most 500 °C or by laser anneal.

The second buffer layer 9 has a lower maximum doping concentration than the first buffer layer 8. Exemplarily, the doping concentration in the second buffer layer 9 is homogeneous. Thus, the first and second buffer layer 8, 9 can be distinguished by the doping concentration decreasing from the maximum doping concentration of the first buffer layer 8 towards the collector side 27, and either the doping concentration rises again to a maximum doping concentration of the second buffer layer 9 or the doping concentration decreases till a constant doping level of the second buffer layer is reached.

As the electric field has already been stopped in the first buffer layer 8, the second buffer layer 9 is a field-free layer in the finalized insulated gate bipolar transistor during operation of the device.

Afterwards, in step (h) a p third dopant is applied at the collector side 27. The third dopant may be applied by implanting a p third dopant, exemplarily Boron, or by growing/depositing a p pre-doped polycrystalline or amorphous Silicon layer. Implantation may be performed at energies between 10 to 100 keV. The third dopant may be implanted with a dose of 1 * 10¹³ cm⁻² up to 5 * 10¹⁵ cm⁻². In case of implantation, the second buffer layer thickness 90 is reduced by the implanted dopant, whereas by the deposition of a p pre-doped polycrystalline or amorphous Silicon layer the second buffer layer thickness 90 is maintained when forming the collector layer 6. The collector layer 6 may have a collector layer thickness 60 up to 2 µm or up to 1 µm. The maximum doping concentration of the collector layer may be ≥ (i.e. equal to or larger than) 1 * 10¹⁶ cm⁻³. As an upper limit the maximum doping concentration may be ≤ (i.e. equal to or less than) 1 * 10²⁰ cm⁻³.

The collector layer 6 is formed by annealing the third dopant (FIG 10). Exemplary anneal temperatures are at most 500 °C or a laser anneal may be performed.

All annesteps (e), (g) and (i) may be performed separately, i.e. the first buffer layer 8, second buffer layer 9 and collector layer 6 are formed after each other. That means that step (e) may be performed before step (f) and step (g) may be performed before step (h). Alternatively, it is also possible to combine anneal steps, i.e. apply the first, second and third dopant and to anneal simultaneously or at least to anneal two of the dopants together in one anneal step. In an exemplary embodiment, annealing is performed at a temperature of at least 400 °C for any or two or all anneal steps (e), (g) and (i).

Additionally to the first buffer layer 8 and second buffer layer 9, a third buffer layer 95 may be formed, which is arranged deeper in the substrate than the first buffer layer 8, i.e. between the first buffer layer 8 and the drift layer 5. The third buffer layer 95 may be formed by implantation of Hydrogen, either at a single implant energy or at a plurality of implantation energies. Exemplary maximum implant energy is ≤ 500 keV, resulting in an implantation depth ≤ 5 µm. Doses of 1 * 10¹³ cm⁻² up to 1 * 10¹⁵ cm⁻² may be used, resulting in a maximum doping concentration of the third buffer layer 95 of 5 * 10¹⁴ cm⁻³ up to 5 * 10¹⁶ cm⁻³. Annealing may be performed at a temperature of ≤ 450 °C. Exemplarily, the third buffer layer 95 is formed before having formed the second buffer layer 9 (i.e. before step (f) so that a lower implantation energy can be applied for the third buffer layer 95. In this case, the third buffer layer 95 may be formed before or after having formed the first buffer layer 8.). Exemplarily, after having formed the third buffer layer 95, no temperature higher than 450 °C is applied to the third buffer layer 95, i.e. either laser anneal is used for subsequent annealing or subsequent annealing temperatures are limited to this limit.

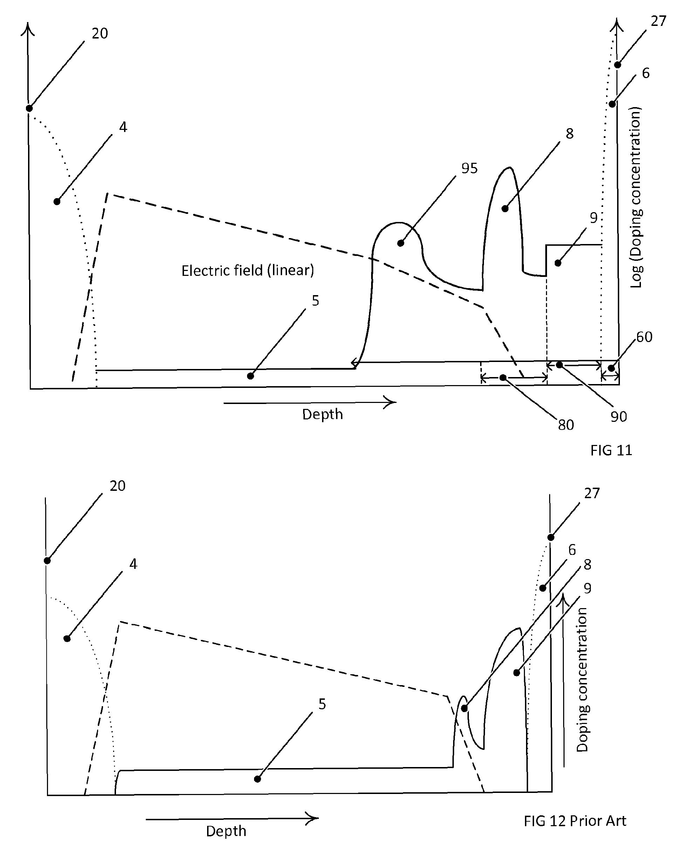

FIG 11 shows the doping profile for an inventive device with first, second and third buffer layer 8, 9, 95 through the line along A - - A of FIG 2, but with additional third buffer layer 95. The first and third buffer layer 8, 95 may be distinguished by the local n doping concentration minimum between these layers. The third buffer layer 95 may be distinguished from the drift layer 5 by the doping concentration decreasing from the maximum doping concentration of the third buffer layer 95 to the doping concentration of the drift layer 5.

Such an additional third buffer layer 95 with lower maximum doping concentration than the first buffer layer 8 may improve soft punch-through properties of the device, i.e. the electric field is stopped more softly, but still in a short distance and with a minimum doping concentration required for the electric field stopping.

After all layers have been formed on the collector side 27, a collector electrode 25 is formed on the collector side 27, which is in contact to the collector layer 6. The collector electrode 25 may be formed together with an emitter electrode 2 on the emitter side 20, which is in contact to the source layer 3 and base layer 4 on the emitter side 20, but the electrodes may also be formed separately at any appropriate manufacturing step. Exemplarily, the emitter electrode 2 may be formed after step (b) and before step (c).

FIG 2 shows an inventive IGBT with a gate electrode 7 comprising a gate layer 70 and first and second insulating layers 72, 74. An n doped source layer 3 and a p doped base layer 4 contact an emitter electrode 2. The base layer 4 separates the source layer 3 from the n- doped drift layer 5, which is arranged on the base layer 4 towards the collector side 27. On the drift 5, a first buffer layer 8, then a second buffer layer 9 and then a collector layer 6 are arranged. The collector layer 6 contacts a collector electrode 25. The first buffer layer 8 has a higher maximum doping concentration than the second buffer layer 9. The second buffer layer 9, which is arranged below the collector layer 6 is a field free layer during operation of the device. The first buffer layer 8 having a first buffer layer thickness 80 of at most 2 µm is arranged below the second buffer layer 9. The first buffer layer 8 has a higher maximum doping concentration than the second buffer layer 9. The maximum doping concentration of the first buffer layer 8 and the first buffer layer thickness 80 are so high that the electric field is completely stopped in the first buffer layer 8 so that the second buffer layer 9 is a field-free layer.

The first buffer layer 8 may have a maximum doping concentration between 1 * 10¹⁶ cm⁻² and 5 * 10¹⁷ cm⁻³, exemplarily having Phosphorous as first dopant in the first buffer layer 8. The first buffer layer thickness 80 may be up to 2 µm or up to 1 µm.

The second buffer layer 9 may have a maximum doping concentration between 1 * 10¹⁴ cm⁻³ and 1 * 10¹⁶ cm⁻³. The second buffer layer thickness 90 may be between 0.5 and 5 µm or between 0.5 and 2 µm. The second buffer layer 9 may be an amorphous or polycrystalline layer, which is doped with an n second dopant, which is exemplarily Phosphorous.

The inventive IGBT may further comprise an n doped third buffer layer 95 between the first buffer layer 8 and the drift layer 5, which is arranged up to 5 µm from the collector side 27 and which has a lower maximum doping concentration than the first buffer layer 8. The dopant for the third buffer layer 95 is Hydrogen.

Fig. 1 shows the doping profile for an inventive IGBT through a cut along the line A - A in FIG 2 or 3. The doping concentration of the p doped base layer 4 and collector layer 6 are shown by a dotted line, whereas the doping concentration of the n doped drift layer 5 and the first and second buffer layer 8, 9 is shown by a continuous line. Additionally, it is shown that the electric field (dashed line) is stopped in the first buffer layer 8, i.e. the second buffer layer 9 is a field-free layer. Furthermore, the figure shows that the thicknesses 60, 80 and 90 are measured as the extension of the layer in depth direction (i.e. in a direction perpendicular to the collector side 27). Exemplarily, the first buffer layer thickness 80 is measured from the interface to the deepest point of the second buffer layer 9 till the constant doping concentration of the drift layer 5 is reached.

FIG 11 shows additionally to the layers of FIG 1 a third buffer layer 95, which is arranged between the first buffer layer 8 and the drift layer 5. A third buffer layer depth 96 is shown as the maximum distance, to which the layer extends from the collector side 27 (FIG 11).

FIG 3 shows another inventive embodiment, in which the semiconductor device additionally has an n doped short layer 65, which is arranged in the same plane parallel to the collector side 27 as the collector layer 6. The short layer 65 alternates with the collector layer 6, exemplarily each of the layers comprises a plurality of regions (i.e. either n regions or p regions), which alternate with each other. Such a device is called a reverse-conducting IGBT.

In the preceding description n doped layers have been used as an example of layers of a first conductivity type (e.g. first and second buffer layer 8, 9) and p doped layers as an example for layers of a second conductivity type (e.g. collector layer 6), but the layers can also be of the opposite conductivity type.

### Reference list

- 1: substrate
- 2: emitter
- 20: emitter side
- 23: layers on the emitter side
- 25: collector electrode
- 27: collector side
- 3: source layer
- 4: base layer
- 5: drift layer
- 6: collector layer
- 60: collector layer thickness
- 65: short layer
- 7: gate electrode
- 70: gate layer
- 72: first insulating layer
- 74: second insulating layer
- 8: first buffer layer
- 80: first buffer layer thickness
- 82: first dopant
- 88: deep buffer layer
- 9: second buffer layer
- 90: second buffer layer thickness
- 95: third buffer layer
- 96: third buffer layer depth
- 98: shallow buffer layer

## Claims

1. A method for manufacturing an insulated gate bipolar transistor comprising following steps:
(a) providing a lowly doped substrate (1) of a first conductivity type having an emitter side (20) and a collector side (27) opposite to the emitter side (20),
(b) forming layers of the first conductivity type and of a second conductivity type, which is different from the first conductivity type, on the emitter side (20),
(c) thinning the substrate (1) on the collector side (27),
(d) implanting a first dopant (82) of the first conductivity type into the substrate (1) from the collector side (27) into a depth of at most 2 µm,
(e) forming a first buffer layer (8) by annealing the first dopant (82),
(f) applying a surface layer comprising a second dopant of the first conductivity type on top of the substrate on the collector side (27),
(g) forming a second buffer layer (9) by annealing the second dopant, wherein the second buffer layer (9) having a lower maximum doping concentration than the first buffer layer (8),
(h) applying a third dopant of the second conductivity type at the collector side (27),
(i) forming a collector layer (6) by annealing the third dopant.

2. The method according to claim 1, **characterized in, that** in step (f) applying an amorphous silicon layer or a polycrystalline silicon layer as the surface layer.

3. The method according to claim 2, **characterized in, that** in step (f) the surface layer is pre-doped with the second dopant.

4. The method according to claim 2 or 3, **characterized in, that** in step (f) implanting the second dopant.

5. The method according to any of the claims 1 to 5, **characterized in, that** in step (f) applying the surface layer having a thickness of 0.5 to 5 µm or of 0.5 to 2 µm.

6. The method according to any of the claims 1 to 4, **characterized in, that** in step (d) implanting phosphorous as first dopant.

7. The method according to any of the claims 1 to 6, **characterized in, that** in step (d) implanting the first dopant into a depth of at most 1 µm.

8. The method according to any of the claims 1 to 7, **characterized in, that** in step (d) implanting the first dopant with an implant energy between 100 keV up to 600 keV.

9. The method according to any of the claims 1 to 8, **characterized in, that** in step (h) implanting the third dopant into the second buffer layer (9) or growing a polycrystalline or amorphous silicon layer pre-doped with the third dopant on top of the second buffer layer (9).

10. The method according to any of the claims 1 to 9, **characterized in, that** in at least one of the steps (e), (g) and (i) annealing at a temperature up to 500 °C.

11. The method according to any of the claims 1 to 10, **characterized in, that** implanting hydrogen at the collector side (27) into a depth of at most 5 µm and forming a third buffer layer (95) by annealing the hydrogen.

12. An insulated gate bipolar transistor comprising a substrate (1) having an emitter side (20) and a collector side (27) opposite to the emitter side (20), wherein
a collector layer (6) of a second conductivity type is arranged on the collector side (27),
a second buffer layer (9) of a first conductivity type different than the second conductivity type and having a second buffer layer thickness (90) is arranged below the collector layer (6),
a first buffer layer (8) having a first buffer layer thickness (80) of at most 2 µm is arranged below the second buffer layer (9),
wherein the first buffer layer (8) has a higher maximum doping concentration than the second buffer layer (9).

13. The insulated gate bipolar transistor according to claim 12, **characterized in, that** at least one of the first buffer layer (8) has a maximum doping concentration between 1 * 10¹⁶ cm⁻² and 5 * 10¹⁷ cm⁻³ and the second buffer layer (9) has a maximum doping concentration between 1 * 10¹⁴ cm⁻³ and 1 * 10¹⁶ cm⁻³ or between 1 * 10¹⁶ cm⁻³ up to 1 * 10¹⁷ cm⁻³.

14. The insulated gate bipolar transistor according to any of the claims 12 or 13, **characterized in, that**
at least one of the first buffer layer thickness (80) is up to 2 µm or up to 1 µm and the second buffer layer thickness (90) is between 0.5 and 5 µm or between 0.5 and 2 µm.

15. The insulated gate bipolar transistor according to any of the claims 12 to 14, **characterized in, that** the insulated gate bipolar transistor comprises a third buffer layer (95) of the first conductivity type below the first buffer layer (8), which is arranged up to 5 µm from the collector side (27) and which has a lower maximum doping concentration than the first buffer layer (8).
